# EUROPEAN PATENT APPLICATION

(11) **EP 4 524 119 A1**
(43) Date of publication of application: **19.03.2025**
(21) Application number: 23803479.7
(22) Date of filing: 28.04.2023
(51) Int. Cl.: C03C 25/1095, C03C 25/40, H05K 1/03, D06M 13/224, D06M 13/513, D03D 15/267

(54) **GLASS CLOTH TREATMENT LIQUID AND SURFACE TREATED GLASS CLOTH**

(30) Priority: 09.05.2022 JP 2022077058
(71) Applicant: SHIN-ETSU CHEMICAL CO., LTD., Tokyo 1000005 (JP)
(72) Inventor: YASUDA, Shigeki, Annaka-shi Gunma 379-0224 (JP); ITOKAWA, Hajime, Annaka-shi Gunma 379-0224 (JP)
(74) Representative: Mewburn Ellis LLP
(86) International application number: PCT/JP2023/016797
(87) International publication number: WO 2023/219000

(57) **Abstract**

Provided is a glass cloth treatment liquid in which 0.05-2.0 mass% of a methacrylamide group-containing organosilicon compound represented by formula (1) is dissolved in water, wherein the content of a dimethacrylamide group-containing organosilicon compound represented by formula (2) is less than 1 mass part per 100 mass parts of the methacrylamide group-containing organosilicon compound represented by formula (1). 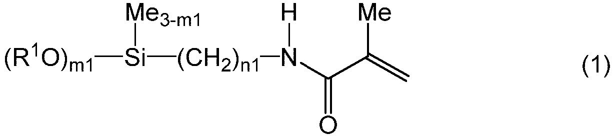 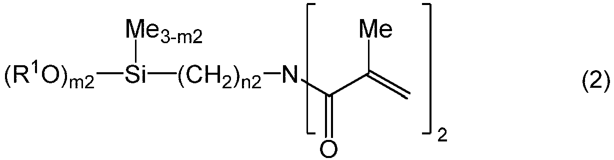 (In the formulae, R¹ each independently represents a C1-C10 alkyl group or a C6-C10 aryl group, Me represents a methyl group, m1 and m2 represent an integer of 1-3, and n1 and n2 represent an integer of 1-12.)

## Description

### TECHNICAL FIELD

The present invention relates to a glass cloth treatment solution and a surface-treated glass cloth. More particularly, the invention relates to a glass cloth treatment solution which includes a methacrylamide group-containing organosilicon compound, and to a glass cloth that has been surface treated with this treatment solution.

### BACKGROUND ART

With the trend today toward higher performance and faster communications in information devices such as smartphones, remarkable advances are being made toward achieving, in the printed wiring boards used in such devices, higher densities and ultrathin dimensions and also lower permittivity and lower dielectric loss tangent. Laminates produced by stacking prepregs obtained by impregnating a glass cloth with an epoxy resin or other thermosetting resin (referred to below as the "matrix resin") and curing under applied heat and pressure are widely used as the insulation material in such printed wiring boards. Given the growing demand for such laminates, there exists a desire for improved productivity.

However, because the glass cloth serving as the board material has a low strength, there is a limit to the resin rate of application to glass cloth, making it difficult to increase the productivity.

The approach generally taken to increase the strength of glass cloth is to react a silane compound agent with silanol groups on the glass cloth. Treatment with various types of silane coupling agents have hitherto been investigated, but the strength thus achieved has been inadequate.

Also, when a silane coupling agent is used to increase the strength of the glass cloth, it is generally used in the form of an aqueous solution obtained by dissolving about 1 wt% of silane coupling agent in water. A compound such as the 3-methacryloxypropyltrimethoxysilane reported in Patent Document 1 is typical of the silane coupling agent used in glass cloth treatment solutions.

However, a drawback of glass cloth treatment solutions that use 3-methacryloxypropyltrimethoxysilane is that, because the condensation reaction on the silanol groups that form due to hydrolysis proceeds gradually, the storage stability is low and the pot life is short.

Patent Document 2 discloses a methacrylamide group-containing silane coupling agent as a silane coupling agent for use in treating glass cloth. Laminates which use glass fibers treated with this silane coupling agent reportedly have excellent heat resistance and other properties, but this silane coupling agent uses a mixture of the compound obtained by reacting 1 equivalent of methacryloyl chloride with 3-aminopropyltriethoxysilane and the compound obtained by reacting two equivalents of methacryloyl chloride with 3-aminopropyltriethoxysilane. The dimethacrylamide compound obtained by reacting two equivalents has a high water repellency, and so the aqueous solution has a low shelf stability.

### PRIOR ART DOCUMENTS

### PATENT DOCUMENTS

Patent Document 1: WO 2020/194772
Patent Document 2: JP-A H05-25219

### SUMMARY OF INVENTION

### TECHNICAL PROBLEM

The present invention was arrived at in light of the above circumstances. The objects of the invention are to provide a glass cloth treatment solution which contains a methacrylamide group-containing organosilicon compound and has an excellent shelf stability, and to provide a surface-treated glass cloth of excellent strength which has been surface-treated with this glass cloth treatment solution.

### SOLUTION TO PROBLEM

The inventors have conducted intensive investigations aimed at resolving the above problems and have discovered as a result that an aqueous solution which includes a methacrylamide group and organooxy group-containing organosilicon compound in a specific concentration and includes substantially no dimethacrylamide group-containing organosilicon compound has an excellent stability. This discovery ultimately led to the present invention.

That is, the invention provides:
1. A glass cloth treatment solution comprising from 0.05 to 2.0 wt% of a methacrylamide group-containing organosilicon compound of formula (1) below dissolved in water,
   wherein the treatment solution has a content of dimethacrylamide group-containing organosilicon compound of formula (2) below that is less than 1 part by weight per 100 parts by weight of the methacrylamide group-containing organosilicon compound of formula (1) 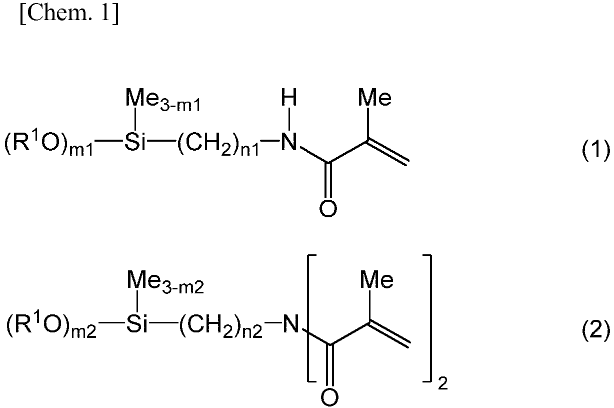 (wherein each R¹ is independently an alkyl group of 1 to 10 carbon atoms or an aryl group of 6 to 20 carbon atoms, Me stands for a methyl group, m1 and m2 are each integers from 1 to 3, and n1 and n2 are each integers from 1 to 12);
2. The glass cloth treatment solution of 1 above wherein, in formulas (1) and (2), R¹ is a methyl group and n1 and n2 are both 3;
3. The glass cloth treatment solution of 1 or 2 above, wherein the water is water that has been adjusted to acidity;
4. A surface-treated glass cloth having a surface treated with the glass cloth treatment solution of 1 or 2 above;
5. The surface-treated glass cloth of 4 above, wherein from 0.05 to 0.5 wt% of the methacrylamide group-containing organosilicon compound of formula (1) is deposited on the glass cloth;
6. The surface-treated glass cloth of 4 above, wherein the glass cloth has a tensile strength with respect to cloth weight (g/mm²) which is at least 2.1 times the tensile strength prior to surface treatment;
7. A prepreg comprising the surface-treated glass cloth of 4 above and a matrix resin impregnated into the surface-treated glass cloth; and
8. A printed wiring board using the prepreg of 7 above.

### ADVANTAGEOUS EFFECTS OF INVENTION

The glass cloth treatment solution of the invention has an excellent shelf stability. In addition, glass cloth treated with the glass cloth treatment solution of the invention has an excellent strength and therefore can be suitably used in printed wiring boards and the like, enabling productivity during board manufacture and board reliability to be enhanced.

### DESCRIPTION OF EMBODIMENTS

The invention is described in detail below.

### [Glass Cloth Treatment Solution]

The glass cloth treatment solution of the invention (sometimes referred to below as the "treatment solution") is an aqueous solution which includes a methacrylamide group-containing organosilicon compound of formula (1) below and includes substantially no dimethacrylamide group-containing organosilicon compound of formula (2) below.

In this invention, "includes substantially no" means that the content of Compound (2) is less than 1 part by weight per 100 parts by weight of Compound (1); less than 0.5 part by weight is preferred, and 0 part by weight is more preferred.

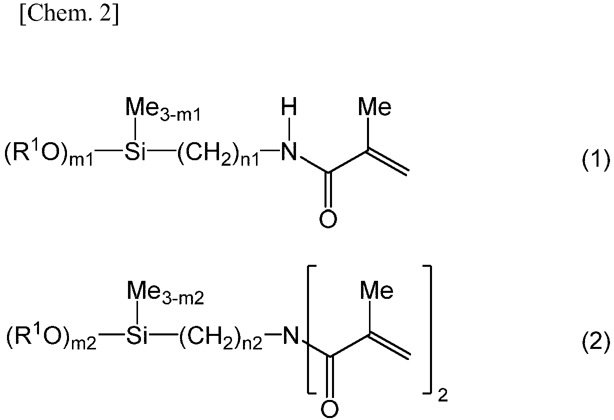

In the formulas, each R¹ is independently an alkyl group of 1 to 10 carbon atoms, preferably 1 to 8 carbon atoms, and more preferably 1 to 6 carbon atoms or an aryl group of 6 to 20 carbon atoms, preferably 6 to 10 carbon atoms, and more preferably 6 to 8 carbon atoms; Me stands for a methyl group; m1 and m2 are each an integer from 1 to 3; and n1 and n2 are each an integer from 1 to 12.

The alkyl group of 1 to 10 carbon atoms represented by R¹ may be linear, branched or cyclic. Specific examples include methyl, ethyl, n-propyl, i-propyl, n-butyl, s-butyl, t-butyl, n-pentyl, n-hexyl, n-heptyl, n-octyl, n-nonyl, n-decyl, cyclopropyl, cyclobutyl, cyclopentyl, cyclohexyl, cycloheptyl and cyclooctyl groups.

Specific examples of aryl groups of 6 to 20 carbon atoms include phenyl, α-naphthyl and β-naphthyl groups.

Of these, R¹ is preferably an alkyl group of 1 to 3 carbon atoms; methyl and ethyl groups are more preferred; a methyl group is even more preferred.

The subscripts m1 and m2 each represent an integer from 1 to 3, preferably 2 or 3. The subscripts n1 and n2 each represent an integer from 1 to 12; from the standpoint of acquiring starting materials, an integer from 1 to 8 is preferred, an integer from 1 to 4 is more preferred, and 3 is even more preferred.

Therefore, Compound (1) is more preferably a compound in which R¹ is a methyl group or an ethyl group and n1 is 3, and most preferably a compound in which R¹ is a methyl group and n1 is 3. Accordingly, examples of Compound (2) include compounds in which R¹ is a methyl group or an ethyl group, and n2 is 3; and in particular compounds in which R¹ is a methyl group and n2 is 3.

Specific examples of Compound (1) include, but are not limited to, methacrylamide methyltrimethoxysilane, methacrylamide methylmethyldimethoxysilane, methacrylamide methyltriethoxysilane, methacrylamide methylmethyldiethoxysilane, 3-methacrylamide propyltrimethoxysilane, 3-methacrylamide propylmethyldimethoxysilane, 3-methacrylamide propyltriethoxysilane, 3-methacrylamide propylmethyldiethoxysilane, 4-methacrylamide butyltrimethoxysilane, 4-methacrylamide butylmethyldimethoxysilane, 4-methacrylamide butyltriethoxysilane, 4-methacrylamide butylmethyldiethoxysilane, 8-methacrylamide octyltrimethoxysilane, 8-methacrylamide octylmethyldimethoxysilane, 8-methacrylamide octyltriethoxysilane, 8-methacrylamide octylmethyldiethoxysilane, 12-methacrylamide dodecyltrimethoxysilane, 12-methacrylamide dodecylmethyldimethoxysilane, 12-methacrylamide dodecyltriethoxysilane and 12-methacrylamide dodecylmethyldiethoxysilane. One of these may be used alone or two or more may be used together.

Of these, compounds of the formulas shown below are preferred. From the standpoint of compound synthesis and preparation of the aqueous solution, Compound (1-1) and Compound (1-3) are especially preferred. In the following formulas, "Me" stands for a methyl group and "Et" stands for an ethyl group.

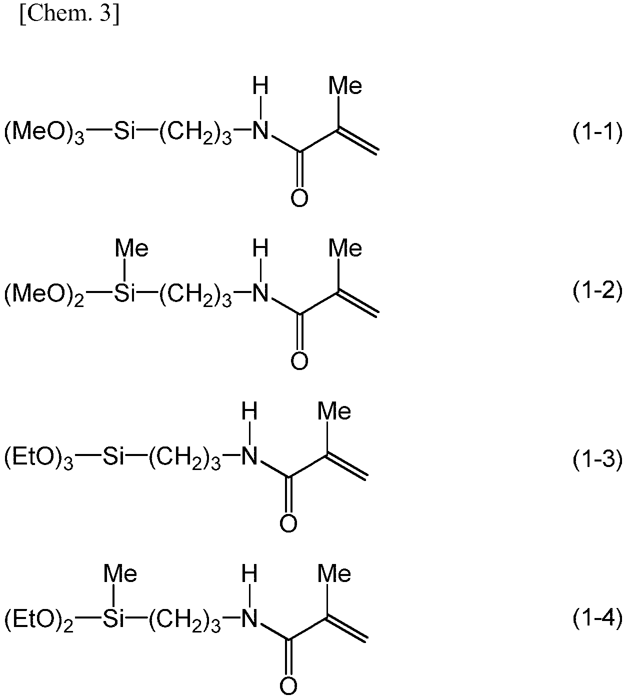

The method of synthesizing Compound (1) is not particularly limited. A known method of synthesis may be used for this purpose. For example, in accordance with the method described in JP No. 3561501, the compound can be obtained by reacting a methacrylate ester such as methyl methacrylate with an aminoalkylalkoxysilane such as 3-aminopropyltrimethoxysilane in the presence of a polymerization inhibitor and an amidation catalyst at a temperature of between about 100°C and 200°C.

Although the glass cloth treatment solution of the invention includes substantially no Compound (2), specific, non-limiting, examples of Compound (2) include N,N-dimethacrylamide methyltrimethoxysilane, N,N-dimethacrylamide methylmethyldimethoxysilane, N,N-dimethacrylamide methyltriethoxysilane, N,N-dimethacrylamide methylmethyldiethoxysilane, 3-(N,N-dimethacrylamide) propyltrimethoxysilane, 3-(N,N-dimethacrylamide) propylmethyldimethoxysilane, 3-(N,N-dimethacrylamide) propyltriethoxysilane, 3-(N,N-dimethacrylamide) propylmethyldiethoxysilane, 4-(N,N-dimethacrylamide) butyltrimethoxysilane, 4-(N,N-dimethacrylamide) butylmethyldimethoxysilane, 4-(N,N-dimethacrylamide) butyltriethoxysilane, 4-(N,N-dimethacrylamide) butylmethyldiethoxysilane, 8-(N,N-dimethacrylamide) octyltrimethoxysilane, 8-(N,N-dimethacrylamide) octylmethyldimethoxysilane, 8-N,N-dimethacrylamide) octyltriethoxysilane, 8-(N,N-dimethacrylamide) octylmethyldiethoxysilane, 12-(N,N-dimethacrylamide) dodecyltrimethoxysilane, 12-(N,N-dimethacrylamide) dodecylmethyldimethoxysilane, 12-(N,N-dimethacrylamide) dodecyltriethoxysilane and 12-(N,N-dimethacrylamide) dodecylmethyldiethoxysilane. In cases where these compounds are included, one such compound is sometimes included alone; sometimes a plurality of two or more are included.

Of these compounds, those typical of Compound (2) include compounds of the following formulas, especially Compound (2-1) or Compound (2-3). In the formulas below, "Me" stands for a methyl group and "Et" stands for an ethyl group.

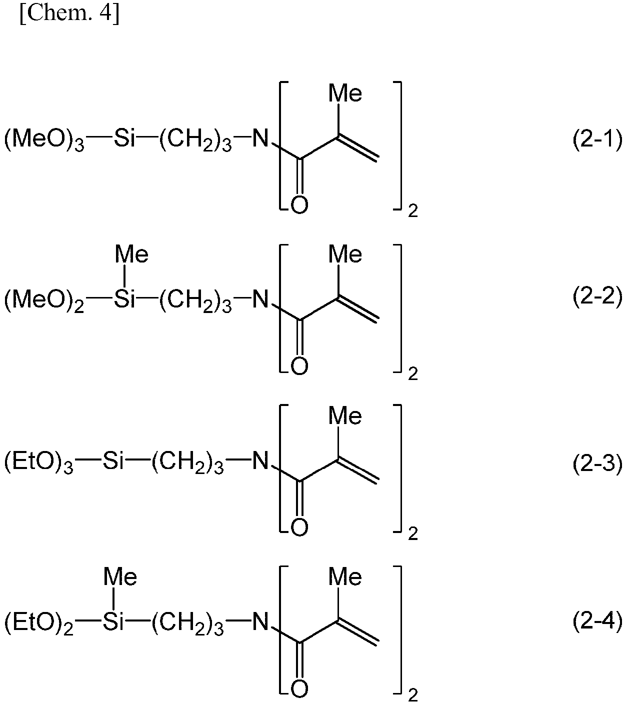

In the glass cloth treatment solution of the invention, Compound (1) is dissolved in water. The Compound (1) content in the glass cloth treatment solution is from 0.05 to 2.0 wt%, preferably from 0.05 to 1.5 wt%, and more preferably from 0.1 to 1 wt%. At a content below 0.05 wt%, the amount of silane coupling agent relative to silanol groups on the glass cloth is inadequate and so the strength of the glass cloth cannot be adequately improved. At a content greater than 2.0 wt%, the shelf stability of the treatment solution is lost, in addition to which the glass cloth becomes rigid, lowering the board material productivity.

The glass cloth treatment solution of the invention can be prepared by mixing together Compound (1) and water, thereby dissolving Compound (1) in water. In this case, Compound (1) may be added to water or water may be added to Compound (1), although a method that adds Compound (1) to water is preferred, and a method that adds Compound (1) to water in a dropwise manner is more preferred.

The addition temperature is preferably between 10°C and 50°C, and more preferably between 15°C and 40°C.

Aside from Compound (1) and water, the glass cloth treatment solution of the invention may include an organic solvent within a range that does not detract from the advantageous effects of the invention.

The organic solvent is not particularly limited, although an organic solvent having excellent compatibility with water is preferred. Examples include alcohols such as methanol, ethanol and isopropanol; ethers such as diethyl ether, tetrahydrofuran and 1,4-dioxane; esters such as ethyl acetate; and ketones such as acetone and methyl ethyl ketone. One such organic solvent may be used alone or two or more may be used in combination.

In cases where the glass cloth treatment solution of the invention does not use the above organic solvent, from the standpoint of stability, it is preferable to use water that has been adjusted to acidity. The acid for adjusting to acidity is exemplified by organic acids such as formic acid, acetic acid and citric acid, and inorganic acids such as hydrochloric acid. When an acid is used, the amount added is preferably from 0.001 to 0.5 wt%, and more preferably from 0.01 to 0.1 wt%, of the overall treatment solution. When an acid is used, water that has been adjusted to acidity by mixing together acid and water beforehand may be used, or acid may be added to an aqueous solution containing Compound (1), thereby adjusting the solution to acidity.

An alkoxy group-containing organosilicon compound other than Compound (1), a silazane compound or the like may be optionally added to the glass cloth treatment solution of the invention in order to enhance adhesion to the glass cloth, such addition being carried out within a range that does not detract from the advantageous effects of the invention.

Also, where necessary, other additives may be added to the glass cloth treatment solution of the invention within ranges that do not detract from the advantageous effects of the invention. Specific examples of such other additives include water-soluble resins, curing catalysts, property modifiers that modify the tensile properties of the cured film that forms, shelf stability improvers, surfactants, metal deactivators, antiozonants, lubricants and pigments.

### [Surface-Treated Glass Cloth]

The surface-treated glass cloth of the invention is a glass cloth whose surface has been treated with the above-described treatment solution. The surface-treated glass cloth of the invention can be obtained by applying the glass cloth treatment solution of the invention to the surface of a glass cloth and, if necessary, drying the glass cloth under applied heat.

### [1] Glass Cloth

The glass fiber making up glass cloth used as the base material is not particularly limited; glass fibers having known glass formulations may be used. Specific examples include E glass, S glass, C glass, D glass, T glass, NE glass and Q glass (quartz glass). The type used is suitably selected according to the intended application.

The form of the glass fiber also is not particularly limited and is exemplified by filament, strand obtained by collecting together from 20 to 400 filaments, and yarn obtained by applying twist to strands.

The thickness of the glass cloth is not particularly limited, and is preferably from 5 to 300 µm, more preferably from 20 to 200 µm, and even more preferably from 30 to 150 µm. The weight per unit surface area also is not particularly limited, and is preferably from 10 to 200 g/m², and more preferably from 20 to 150 g/m².

The weave of the glass cloth, which also is not particularly limited, is exemplified by plain weave, twill weave and satin wave. These are suitably selected according to the intended application. The weave density is suitably selected within a known range.

### [2] Method for Manufacturing Glass Cloth

The method of manufacturing glass cloth to be used as a base material is not particularly limited so long as it includes a glass fiber weaving step, and is exemplified by methods which include the following steps.
(1) Weaving step that weaves glass fiber to obtain a glass cloth
(2) Fiber-opening step that fiber-opens the glass fibers of the glass cloth
(3) Heat cleaning step that removes size adhering to the glass fibers of the glass cloth

### (1) Weaving Step

The weaving step is the step of weaving glass fiber to obtain a glass cloth. Weaving methods include, without particular limitation, methods that involve the use of, for example, an air jet loom, a water jet loom, a rapier loom or a shuttle loom. When weaving is carried out with an air jet loom or the like, polyvinyl alcohol (PVA) or starch may be applied as a secondary size to achieve further lubricity.

### (2) Fiber-Opening Step

The fiber-opening step is the step of fiber-opening the glass fibers of the glass cloth. Examples of fiber-opening methods include, without particular limitation, methods that carry out fiber-opening treatment with sprayed water (fiber-opening with high-pressure water), a vibrowasher, ultrasonic water or a mangle.

### (3) Heat Cleaning Step

The heat cleaning step is a step that removes size remaining on the surface of the glass cloth after it has been woven. When the surface-treated glass cloth is used as a board material, remaining size worsens the dielectric properties, in addition to which surface treatment of the glass cloth becomes inadequate and undesirable effects such poor adhesion with the resin arise.

Examples of heat cleaning methods include methods carried out using a flow-type or batch-type heating oven. Because a flow-type oven incinerates the size all at once at an elevated temperature, problems include a decrease in glass cloth strength and unburnt size. Therefore, a batch-type oven which gradually burns and removes organic matter at between 300°C and 400°C is commonly used.

### [3] Method of Surface Treating Glass Cloth

The method of surface treating glass cloth with the glass cloth treating solution of the invention is not particularly limited. For example, surface treatment may be carried out by a method that includes the following steps.
(11) A treatment solution contacting step that brings the glass cloth treatment solution of the invention into contact with the surface of the glass cloth
(12) A reaction step that reacts silanol groups on the surface of the glass cloth with organooxy groups within Compound (1) included in the glass cloth treatment solution of the invention

### (11) Treatment Solution Contacting Step

The treatment solution contacting step is a step that bring the glass cloth treatment solution of the invention into contact with the surface of the glass cloth. In the treatment solution contacting step, the contacting method is not particularly limited and may be suitably selected from among known techniques. Examples include methods that involve dipping the glass cloth in the glass cloth treatment solution of the invention and methods that involve the use of a roll coater.

### (12) Reaction Step

The reaction step is a step that reacts silanol groups on the surface of the glass cloth with organooxy groups within Compound (1) included in the glass cloth treatment solution of the invention. In the reaction step, the reaction conditions are not particularly limited and should be suitably adjusted according to such factors as the heat resistance of the glass fibers and the amount of glass cloth treatment solution used. The reaction temperature is preferably between 70°C and 200°C, and more preferably between 90°C and 150°C. The reaction time is preferably from 30 seconds to 30 minutes, and more preferably from 1 to 20 minutes. Under such conditions, moisture can be evaporated and Compound (1) can be reacted with silanol groups on the surface of the glass cloth.

The heating method is not particularly limited and should be suitably selected from among known techniques. Examples include methods that involve the use of hot air, infrared light or hot rolls.

In the surface-treated glass cloth of the invention, the amount of Compound (1) applied to the glass cloth serving as the base material is not particularly limited. However, from the standpoint of processability and strength, the amount is preferably from 0.05 to 0.5 wt%, and more preferably from 0.05 to 0.2 wt%. The applied amount of Compound (1) can be measured by the ignition loss method described in JIS R3420: 2013.

The surface-treated glass cloth of the invention has a tensile strength with respect to cloth weight (g/mm²) which is preferably at last 2.1 times, and more preferably at least 2.2 times, the tensile strength prior to surface treatment. Such surface-treated glass cloth has an excellent processability when rendered into a prepreg. In addition, as will be subsequently described, the tensile strength can be measured in accordance with "7.4 Tensile Strength" in JIS R3420: 2013 (General Test Methods for Glass Fibers).

### [Prepreg]

The prepreg of the invention includes the above surface-treated glass cloth and a matrix resin impregnated into this surface-treated glass cloth.

It is possible to render the surface-treated glass cloth of the invention into a prepreg by mixing it with a matrix resin. Because the prepreg obtained using the surface-treated glass cloth of the invention has an excellent strength, it can be suitably used in, for example, printed wiring boards.

A common method of fabricating glass cloth-containing boards, films, prepregs and the like can be employed without particular limitation as the method of fabricating the prepreg of the invention. For example, a method which impregnates a surface-treated glass cloth with a molten matrix resin or a matrix resin-containing solution can be employed.

The matrix resin used in the prepreg of the invention is not particularly limited and may be suitably selected from among hitherto known matrix resins. Examples include heat-curable silicone resins, polyimide resins, maleimide resins, epoxy resins, cyanate resins and (meth)acrylic resins.

The thickness of the inventive prepreg, although not particularly limited, is preferably from 10 to 400 µm, more preferably from 30 to 300 µm, and even more preferably from 40 to 200 µm. Within this range, when the prepreg of the invention is used in, for example, a printed wiring board, copper-clad laminates and other boards can be manufactured.

The prepreg of the invention may be semi-cured (B-staged) beforehand by heating. The B-staging method is not particularly limited. For example, B-staging can be carried out by dissolving the matrix resin in a solvent, impregnating the resulting solution in glass cloth and drying, followed by heating at a temperature of between 80°C and 200°C for a period of 1 to 30 minutes.

### [Printed Wiring Board]

The printed wiring board of the invention is obtained using a prepreg containing the surface-treated glass cloth of the invention. A common printed wiring board manufacturing method may be employed without particular limitation as the method of manufacturing the printed wiring board of the invention. An exemplary method of manufacturing a board involves arranging the prepreg of the invention and copper foil as successive layers, and then pressing and curing the stacked layers under applied heat to form a copper-clad laminate. The method of manufacturing a copper-clad laminate is not particularly limited. For example, production can be carried out by using from 1 to 20 layers, preferably from 2 to 10 layers, of the above prepreg, arranging copper foil on one or both sides of each prepreg, and then pressing and curing the resulting stack under applied heat.

The thickness of the copper foil, although not particularly limited, is preferably from 3 to 70 µm, more preferably from 10 to 50 µm, and even more preferably from 15 to 40 µm. Within this range, a multilayer copper-clad laminate that retains a high reliability can be molded. The copper laminate molding conditions are not particularly limited. For example, molding can be carried out using a multistage press, a multistage vacuum press, continuous molding or an autoclave press at a temperature of between 100°C and 400°C, a pressure of from 1 to 100 MPa and a heating time of from 0.1 to 4 hours. Alternatively, a copper-clad laminate can be molded by combining and molding the prepreg of the invention, copper foil and an inner layer wiring board.

Nor is there any particular limitation on the method of circuit fabrication. Examples include circuit fabrication by drilling holes, metal plating or metal foil etching. Printed wiring boards can also be fabricated by a build-up process which sequentially laminates a matrix resin-containing composition or the inventive prepreg and copper foil.

### EXAMPLES

The invention is illustrated more fully below by way of Synthesis Examples, Examples of the invention and Comparative Examples, although the invention is not limited by these Examples. In the formulas below, "Me" stands for a methyl group and "Et" stands for an ethyl group.

### [1] Synthesis of Organosilicon Compound

### [Synthesis Example 1]

The methacrylamide group-containing organosilicon compound (1-1) represented by the following formula was obtained while referring to JP No. 3561501.

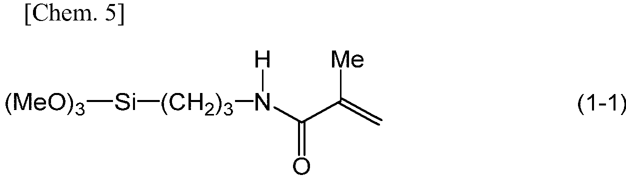

### [Synthesis Example 2]

The methacrylamide group-containing organosilicon compound (1-3) represented by the following formula was obtained while referring to JP No. 3561501.

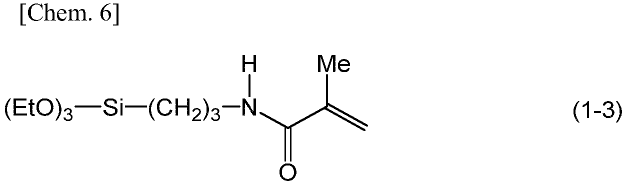

### [Comparative Synthesis Example 1]

A methacrylamide group-containing organosilicon compound and dimethacrylamide group-containing organosilicon compound mixture (3-1) represented by the following formula was obtained while referring to JP-A H05-25219.

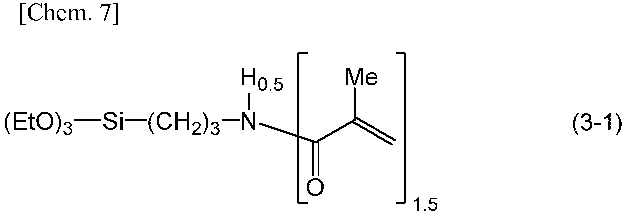

### [2] Production of Glass Cloth Treatment Solution

### [Examples 1-1 to 1-3, Comparative Examples 1-1 to 1-6]

Glass cloth treatment solutions were prepared by the dropwise addition, in accordance with the compounding ratios shown in Table 1, of the compound obtained in Synthesis Example 1 or 2, the mixture obtained in Comparative Synthesis Example 1 or another comparative compound to a 0.05 wt% aqueous solution of acetic acid under 25°C conditions.

The following evaluations were carried out on the resulting glass cloth treatment solutions. The results are presented in Table 1.

### [3] Evaluation of Treatment Solution Stability

The aqueous solutions thus obtained were left at rest in a 25°C environment for 1 day, 7 days or 14 days, after which the appearance was visually checked and rated according to the following criteria.
- O:: Completely dissolved, giving a uniform aqueous solution.
- ×:: Impurities have precipitated out.

### [4] Production of Surface-Treated Glass Cloth

### [Examples 2-1 to 2-3, Comparative Examples 2-1 to 2-6]

An E-glass cloth obtained by 72 hours of heating and desizing at 400°C (thickness, 95 µm; weight per unit surface area, 107 g/m²) was dipped in the glass cloth treatment solutions obtained in Examples 1-1 to 1-3 and Comparative Examples 1-1 to 1-6 and then removed, following which the cloth in each example was dried under 10 minutes of heating at 110°C, giving a surface-treated glass cloth.

### [5] Evaluation of Tensile Strength of Surface-Treated Glass Cloth

Using the AGS-X Autograph from Shimadzu Corporation, the tensile strength with respect to cloth weight (g/mm²) of the surface-treated glass cloth was measured in accordance with JIS R3420: 2013 (General Test Methods for Glass Fibers) and the tensile strength ratio with respect to the untreated glass cloth was calculated. The results are shown in Table 2.

### [6] Measuring Applied Amount of Surface Treatment Agent

The applied amount (wt%) of the compound obtained in Synthesis Example 1 or 2, the mixture obtained in Comparative Synthesis Example 1 or the comparative compounds (surface treatment agents (silane coupling agents)) on surface-treated glass cloth produced in the same way as that used in the above tensile strength tests was measured in accordance with the ignition loss method described in JIS R3420. The results are shown in Table 2.

**[Table 1]**

| | | Example | | | Comparative Example | | | | | |
|---|---|---|---|---|---|---|---|---|---|---|
| | | 1-1 | 1-2 | 1-3 | 1-1 | 1-2 | 1-3 | 1-4 | 1-5 | 1-6 |
| Composition (pbw) | 0.05 wt% aqueous acetic acid | 99.8 | 98.5 | 99.8 | 99.8 | 99.97 | 97.5 | 99.8 | 97.5 | 99.8 |
| | Compound (1-1) | 0.2 | 1.5 | | | 0.03 | 2.5 | | | |
| | Compound (1-3) | | | 0.2 | | | | | | |
| | Mixture (3-1) | | | | 0.2 | | | | | |
| | KBM-503 | | | | | | | 0.2 | 2.5 | |
| | KBM-903 | | | | | | | | | 0.2 |
| Stability of treatment solution | After 1 day | ○ | ○ | ○ | ○ | ○ | ○ | ○ | × | ○ |
| | After 7 days | ○ | ○ | ○ | × | ○ | × | ○ | × | ○ |
| | After 14 days | ○ | ○ | ○ | × | ○ | × | × | × | ○ |

| | | | | | | | | | | |
|---|---|---|---|---|---|---|---|---|---|---|
| • KBM-503: 3-methacryloyloxypropyltrimethoxysilane, from Shin-Etsu Chemical Co., Ltd. • KBM-903: 3-aminopropyltrimethoxysilane, from Shin-Etsu Chemical Co., Ltd. | | | | | | | | | | |

**[Table 2]**

| | Example | | | Comparative Example | | | | | |
|---|---|---|---|---|---|---|---|---|---|
| | 2-1 | 2-2 | 2-3 | 2-1 | 2-2 | 2-3 | 2-4 | 2-5 | 2-6 |
| Tensile strength (N/25 mm) of surface-treated glass cloth with respect to cloth weight (g/mm²) | 3.20 | 3.75 | 3.10 | 3.25 | 1.85 | 3.90 | 2.80 | - | 1.95 |
| Tensile strength ratio relative to untreated glass cloth | 2.3 | 2.7 | 2.2 | 2.3 | 1.3 | 2.8 | 2.0 | - | 1.4 |
| Applied amount of surface treatment agent (wt%) | 0.10 | 0.45 | 0.11 | 0.10 | 0.02 | 1.00 | 0.12 | 0 | 0.2 |

As shown in Tables 1 and 2, the glass cloth treatment solutions of Examples 1-1 to 1-3 had excellent shelf stabilities. Also, the glass cloths that were surface-treated with the glass cloth treatment solutions of Examples 1-1 to 1-3 had excellent tensile strengths.

On the other hand, in Comparative Example 1-1 containing a dimethacrylamide group-containing organosilicon compound, the shelf stability of the glass cloth treatment solution was greatly inferior.

Also, when the proportion of methacrylamide group-containing organosilicon compound in the glass cloth treatment solution was inadequate, the tensile strength of the glass cloth was inferior (Comparative Example 2-2). When the proportion of methacrylamide group-containing organosilicon compound was too high, the shelf stability of the treatment solution was greatly inferior (Comparative Example 1-3).

Glass cloth that was treated with a 3-methacryloyloxypropyltrimethoxysilane-containing glass cloth treatment solution had an inferior tensile strength (Comparative Example 2-4). When the amount of 3-methacryloyloxypropyltrimethoxysilane added was increased in order to enhance the tensile strength, the shelf stability of the treatment solution was greatly inferior (Comparative Example 1-5).

Glass cloth treated with a 3-aminopropyltrimethoxysilane-containing glass cloth treatment solution had an inferior tensile strength (Comparative Example 2-6).

## Claims

1. A glass cloth treatment solution comprising from 0.05 to 2.0 wt% of a methacrylamide group-containing organosilicon compound of formula (1) below dissolved in water,
wherein the treatment solution has a content of dimethacrylamide group-containing organosilicon compound of formula (2) below that is less than 1 part by weight per 100 parts by weight of the methacrylamide group-containing organosilicon compound of formula (1) 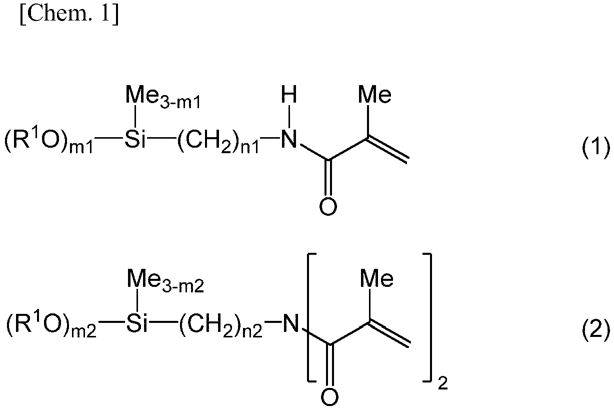 (wherein each R¹ is independently an alkyl group of 1 to 10 carbon atoms or an aryl group of 6 to 20 carbon atoms, Me stands for a methyl group, m1 and m2 are each integers from 1 to 3, and n1 and n2 are each integers from 1 to 12).

2. The glass cloth treatment solution of claim 1 wherein, in formulas (1) and (2), R¹ is a methyl group and n1 and n2 are both 3.

3. The glass cloth treatment solution of claim 1 or 2, wherein the water is water that has been adjusted to acidity.

4. A surface-treated glass cloth having a surface treated with the glass cloth treatment solution of claim 1 or 2.

5. The surface-treated glass cloth of claim 4, wherein from 0.05 to 0.5 wt% of the methacrylamide group-containing organosilicon compound of formula (1) is deposited on the glass cloth.

6. The surface-treated glass cloth of claim 4, wherein the glass cloth has a tensile strength with respect to cloth weight (g/mm²) which is at least 2.1 times the tensile strength prior to surface treatment.

7. A prepreg comprising the surface-treated glass cloth of claim 4 and a matrix resin impregnated into the surface-treated glass cloth.

8. A printed wiring board using the prepreg of claim 7.
